# EUROPEAN PATENT SPECIFICATION

(11) **EP 0 968 885 B1**
(45) Date of publication and mention of the grant of the patent: **14.06.2006**
(21) Application number: 99201875.4
(22) Date of filing: 14.06.1999
(51) Int. Cl.: B60R 16/02

(54) **Cooling an engine control unit**
Abkühlung eines Motorsteuerunggerätes
Refroidissement d'une unité de commande moteur

(30) Priority: 30.06.1998 GB 9814082
(43) Date of publication of application: 05.01.2000
(73) Proprietor: Cummins Engine Company, Ltd., Darlington, County Durham DL1 4PW (GB); Iveco (UK) Ltd., Watford, Hertfordshire WD1 1SR (GB); CNH U.K. LIMITED, Basildon, Essex SS14 3AD (GB)
(72) Inventor: Clamp, Andrew, Co Durham DL1 3TB (GB); Purcell, John J., Marlow, Buckinghamshire SL7 1QW (GB)
(74) Representative: Vandenbroucke, Alberic

(56) References cited:
- EP-A- 0 309 986
- EP-A- 0 697 807
- EP-A- 0 841 842
- DE-A- 2 823 666
- US-A- 4 763 611
- US-A- 5 685 361
- PATENT ABSTRACTS OF JAPAN vol. 1997, no. 09, 30 September 1997 (1997-09-30) & JP 09 126044 A (DENSO CORP), 13 May 1997 (1997-05-13)

## Description

The present invention relates to the cooling of an electronic control unit (ECU) of an engine, in particular a diesel engine.

It is necessary in vehicles that operate in a hot and hostile environment to take special steps to cool the engine electronic control unit, because electronic components may malfunction if they are overheated. Additionally, the heat generated by the ECU will shorten the life of the ECU if not transferred away.

It has previously been proposed to provide a heat exchanger (commonly called a chill plate) for supporting and cooling an ECU. The chill plate comprises a coolant chamber which, in use, is connected in a supply line through which passes fuel flowing from a fuel reservoir to the engine. The chill plate serves to cool the ECU module by transferring heat to the fuel supplied to the engine. The known chill plates, however, have the disadvantage that they can only be used with ECU's having a flat heat sink of conductive material to which the heat generating electronic components are attached.

In EP-A-0 309 986 an engine electronic control unit (ECU) and chill plate assembly is described with a housing comprising: a base on one side of which the components of the ECU are mounted either directly or indirectly (i.e. via a ceramic board), the base being formed with a central pocket for accommodating any components protruding from the rear face of the ECU ceramic board, a recess being formed in the opposite side of the base to the ECU components; an upper enclosure fixed to the base and covering the components; and a closure fixed to to the side of the base to cooperate with the recess to define a cooling water passage, the cooling water passage extending around at least part of the periphery of the central pocket and an area covering the full region of the central pocket to transfer heat to the water from the pocket and a region of the base adjacent the pocket.

In EP-A-O 309 986 the chill plate and ECU assembly comprises a cooling fluid passage which covers the full region of the ECU, thus cooling all components of the ECU, irrespective of the amount of heat the individual components produce. The cooling passage moreover is merely an open space with an inlet and an outlet resulting in an inefficient use of the cooling capacity of the cooling fluid since the fluid is not forced around the ECU components in a predetermined path.

It is therefore an object of the present invention to provide a chill plate that can be used more effectively with different types of ECU's, including ECU's having components that protrude beyond the surface of a flat heat sink to be cooled. Additionally, this design can be incorporated directly into the ECU housing if appropriate.

In accordance with a first aspect of the present invention, there is provided a chill plate for cooling an electronic control unit of an engine, comprising a housing having a flat front face onto which the ECU may be mounted, the housing being formed with a central pocket for accommodating any components protruding from the rear face of the ECU; the chill plate further comprising a passage within the housing through which cooling liquid may flow, wherein the ECU has a rear backing plate comprising a substantially circumferentially provided surface mating with said flat front face of the chill plate and which needs to be cooled, and a box that protrudes from said surface; said passage comprising flow conduits through which fuel flows substantially only around at least part of the periphery of the central pocket to transfer heat to the fuel from the regions of the front face surrounding the pocket.

In order to allow the chill plate to be mounted directly on an engine, the housing is preferably formed with mounting bosses for receiving shock and vibration absorbing rubber bushes.

The housing may conveniently be formed of a metal casting defining an open channel surrounding three sides of the central pocket, and a cover plate for closing the open channel to constitute the fuel flow conduits. The cover plate is preferably welded to the metal casting. In order to improve the thermal efficiency of the chill plate, the open channel may comprise one or more partitions such that the fuel in the flow conduits is constrained to follow a convoluted path.

Conventionally, an ECU has a metal backing plate with the result that when the ECU is fitted to the chill plate there will be two layers of metal between the liquid coolant and the circuit components to be cooled. In order to improve on this arrangement, it is possible to dispense with the closure plate of the chill plate and instead to form the chill plate as part of the ECU housing.

Hence, in accordance with a second aspect of the invention, there is provided an electronic control unit (ECU) for an engine having a rear face and a central box which accommodates components protruding from the rear face of the ECU, and wherein a plate comprising a raised outer wall portion extending around the periphery of the plate is mounted on the ECU in sealing engagement with the rim of the rear face to define in combination with the rear face and the box a chamber for circulation of fuel for cooling the ECU, the chamber comprising a flow conduit through which fuel flows substantially only around at least part of the periphery of the box to transfer heat to the fuel from regions of the rear face of the ECU surrounding the box.

Thus, for high volume applications, all of the features of the invention can be incorporated into the ECU housing instead of requiring a separate housing.

The invention will now be described further, by way of example, with reference to the accompanying drawings, in which :
Figure 1 is an exploded front view of a chill plate of the invention;
Figure 2 is an exploded rear view of the chill plate of Figure 1;
Figure 3 is a perspective rear view of a first type of ECU that may be mounted in the chill plate of Figures 1 and 2;
Figures 4 and 5 are front and rear views, respectively of a second type of ECU that may be mounted on the chill plate of Figures 1 and 2;
Figure 6 is an exploded vertical central section through the chill plate of Figures 1 and 2 and an ECU of the second type;
Figure 7 is an exploded perspective view of the chill plate of Figures 1 and 2 and an ECU of the second type; and
Figures 8 and 9 are respectively front and rear exploded views of an embodiment of the invention in which the chill plate is integrated into the housing of the ECU unit.

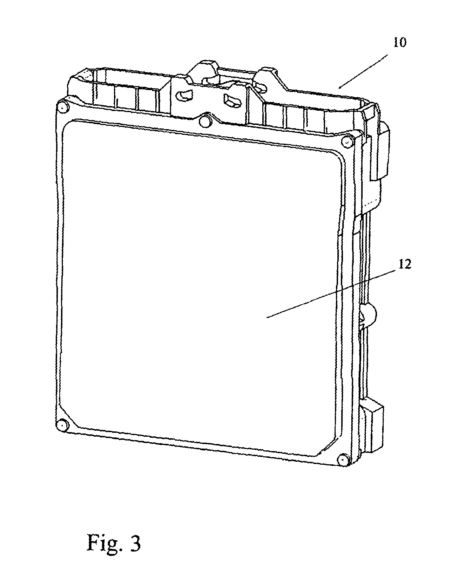

Figure 3 shows a prior art type of ECU 10 that is currently available and in use in engine management systems. This ECU 10 presents no particular problem as it has a flat rear face 12 that needs to be cooled around its periphery. Such an ECU can be cooled using a flat chill plate, as already known in the prior art.

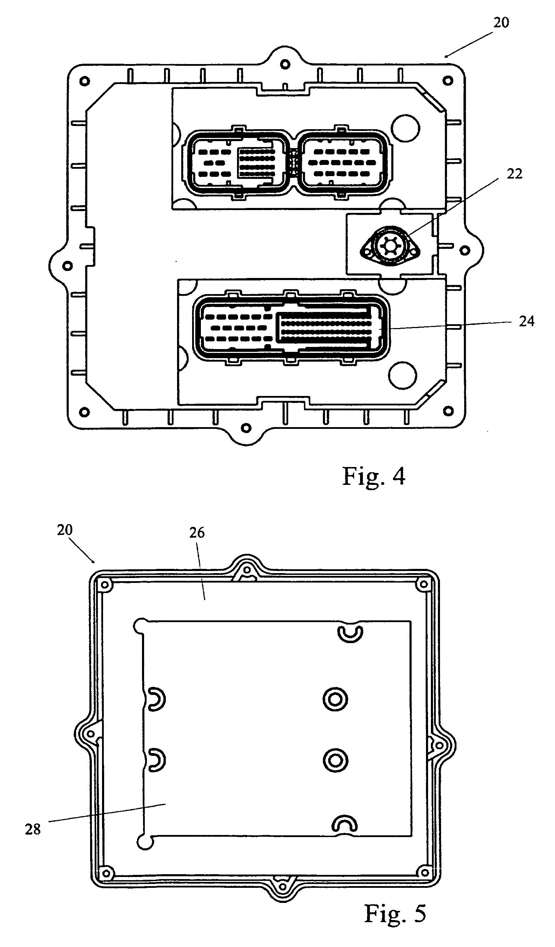

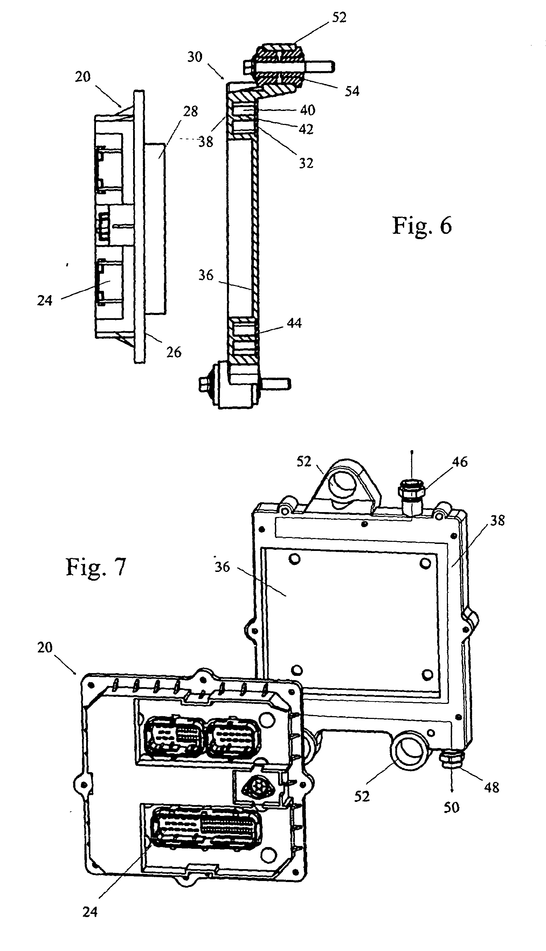

Figures 4 and 5 on the other hand show a different type of ECU 20 that is also currently in use and differs from that of Figure 3. On its front face, the ECU 20 has various electrical connection terminals 22, 24. On its rear face, the ECU 20 has a surface 26 that needs to be cooled and a box 28 that protrudes from that surface. The parts of the rear surface 26 that need to be cooled are located partly circumferentially around the box 28 and it will be clear that such an ECU cannot be cooled using a flat chill plate as the protruding box 28 would prevent the parts of the rear surface 26 that need to be cooled from contacting the chill plate.

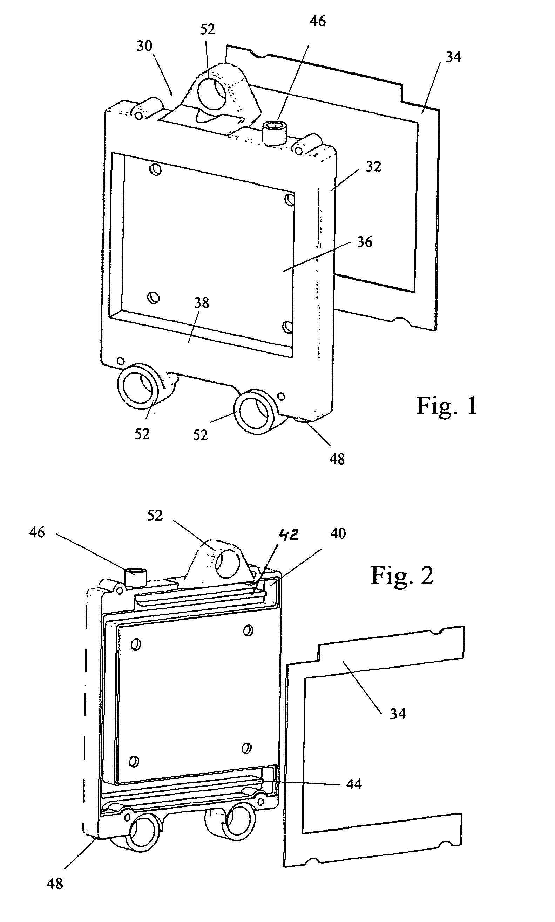

To mitigate this problem and allow the same chill plate to be used with types of ECU's described above, the invention provides a chill plate 30 that is shown in Figures 1 and 2.

The chill plate 30 is formed of two parts that are welded to each other, namely an aluminium casting 32 and a cover plate 34. The casting defines a pocket 36 recessed into the flat front face 38 of the chill plate, which pocket is surrounded on three sides by a channel 40 of U-shaped cross section. When the cover plate 34 is welded or otherwise affixed to the channel 40 in fluid sealing arrangement, flow conduits are formed for fuel that enters the chill plate 30 through a fuel inlet 46 and leaves through a fuel outlet 48. Two partition walls 42, 44 are cast into the upper and lower sides of the channel 40, respectively, to constrain the fuel to follow a convoluted flow path through the flow conduit to increase residence time and the effective heat transfer from the electronic components.

In use, as may be seen from the section of Figure 6 and the exploded perspective view of Figure 7, the ECU 20 of Figures 3 and 4 can be mounted on the chill plate because its protruding box 28 can be accommodated in the pocket 36. The chill plate is connected in series in the pipe leading from the fuel tank to the fuel injection system of the engine. The fuel follows the path shown by the arrow 50 in Figure 7. In particular, the fuel enters from the inlet 46, traverses the upper side of the channel 40 twice, descends along the vertical side and traverses the lower side of the channel 40 twice before leaving through the outlet 48. In the process, the fuel extracts heat from the periphery of the front surface 38 of the chill plate 30 which is in thermal contact with the surface 26 of the ECU 20 that needs to be cooled.

The chill plate 30 is intended for mounting directly on the engine. To reduce transmission of engine vibrations to the ECU, the chill plate has three engine mounting bosses 52 that are designed to receive rubber bushes 54 (Figure 6) which are positioned between the bosses 52 and mounting screws which attach to the engine receiving the ECU 20. These bushes absorb shocks and vibrations and also provide thermal isolation between the chill plate 30 and the engine mounts.

It will be clear that the chill plate 30 can equally well accept an ECU of the type shown in Figure 3 that has no protrusions that inhibit the surface to be cooled from being brought into thermal contact with the cooling surface of the chill plate 30.

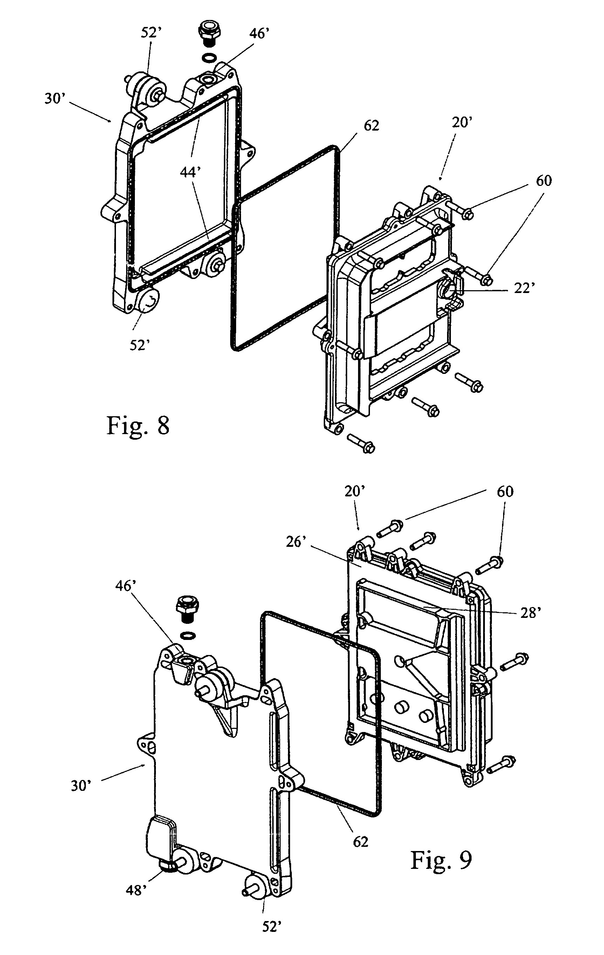

It is possible in high volume applications to integrate the chill plate and the ECU, such an embodiment of the invention being shown in the exploded views of Figures 8 and 9. Such an arrangement eliminates the need for the cover 34 and the need to have a fluid sealed joint between the cover 34 and the chill plate 30. It is believed that the construction of this embodiment of the invention will be self-evident to the person skilled in the art and to emphasize the similarity, components serving a like function have been allocated like reference numerals but with an addition of a prime to each numeral.

As with the ECU 20 shown in Figures 4 and 5, the ECU 20' of Figures 8 and 9 has electrical connectors 22' on its front face and a box 28' containing electrical components projecting from its rear face 26'. A plate 30' formed as a casting of aluminium or other heat conductive material is mounted by means of screws 60 directly onto the rear face 26' of the ECU 20' and is sealed against it by means of a resilient gasket or rubber ring 62 received in a continuous perimeter groove in the plate 30'. When the plate 30' is assembled to the ECU 20', it defines a sealed cooling chamber having a central pocket constituted by the box 28'. The region of the chamber surrounding the box 28' is divided by a partition wall 44' formed as part of the casting of the plate 30' into a convoluted flow path like the path shown in Figure 2 that surrounds and cools the periphery of the central pocket. Fuel enters and leaves the flow path through connectors 46' and 48'.

The seal 62 prevents fuel from leaking out of the cooling chamber but it is not necessary to take any steps to prevent fuel from reaching the space between the central box 28' and the plate 30'. As the maximum depth of the box 28' is selected to closely fit the facing side of the plate 30', there will be only a small leakage from the convoluted fuel flow path which will not detract significantly from the cooling of the peripheral regions of the ECU 20'.

The plate 30' can once again be used to mount the ECU 20' to an engine and to this end it is provided with bosses 52' for receiving shock absorbing mounting bushes.

## Claims

1. An electronic control unit (ECU) of an engine, with a chill plate (30) for cooling, the chill plate (30) comprising a housing (32, 34) having a flat front face (38) onto which the ECU (20, 20') may be mounted, the housing being formed with a central pocket (36) for accommodating any components (28) protruding from the rear face (26) of the ECU; the chill plate (30) further comprising a passage (40) within the housing through which cooling liquid may flow, and wherein
the ECU (20) has a rear backing plate comprising a substantially circumferentially provided surface (26) mating with said flat front face (38) of the chill plate and which needs to be cooled, and a box (28) that protrudes from said surface (26); said passage (40) comprising flow conduits (40) through which fuel flows substantially only around at least part of the periphery of the central pocket (36) to transfer heat to the fuel from the regions of the front face (38) surrounding the pocket (36).

2. An electronic control unit (ECU) with a chill plate according to claim 1, **characterized in that** the chill plate housing (32.34) is formed with mounting bosses (52) for receiving shock and vibration absorbing rubber bushes (54), to allow the chill plate (30) to be mounted directly on an engine.

3. An electronic control unit with a chill plate according to claim 1 or 2 **characterized in that** the chill plate housing (32, 34) is formed of a metal casting defining an open channel (40) surrounding three sides of the central pocket (36), and a cover plate (34) for closing the open channel (40) to constitute the fuel flow conduits.

4. An electronic control unit with a chill plate according to claim 3, **characterized in that** the cover plate (34) is welded to the metal casting.

5. An electronic control unit with a chill plate according to claim 3 or 4, **characterized in that** the open channel (40) comprises one or more partitions (42, 44) such that the fuel in the flow conduits is constrained to follow a convoluted path.

6. An electronic control unit (ECU) (20') for an engine having a rear face (26') and a central box (28') which accommodates components protruding from the rear face (26') of the ECU (20') , wherein
a plate (30') comprising a raised outer wall portion extending around the periphery of the plate (30') is mounted on the ECU (20') in sealing engagement with the rim of the rear face (26') to define in combination with the rear face (26') and the box (28') a chamber for circulation of fuel for cooling the ECU (20'), the chamber comprising a flow conduit through which fuel flows substantially only around at least part of the periphery of the box (28') to transfer heat to the fuel from regions of the rear face (26') of the ECU (20') surrounding the box (28').

7. An electronic control unit according to claim 6, **characterized in that** the plate (30') is formed as a metal casting with at least one raised partition wall (44') which divides the regions of the chamber surrounding the central box (28') into a convoluted flow conduit.

8. An electronic control unit according to claim 6 or 7, **characterized in that** a bottom floor of the central box (28') extends closely adjacent the plate (30') to constrain the fuel to flow in a path around at least a part of the periphery of said central box (28').

9. An electronic control unit according to claims 6 to 8, **characterized in that** a continuous seal element (62) extends around the periphery of the central box (28') for sealing fuel in said chamber.

10. An electronic control unit according to any of the claims 6 to 9, **characterized in that** the ECU (20') is releasably fastened to the plate (30') by means of a plurality of screws (60).

## Patentansprüche

1. Elektronische Steuereinheit (ECU) eines Motors mit einer Kühlplatte (30) zum Kühlen, wobei die Kühlplatte (30) ein Gehäuse (32, 34) mit einer ebenen vorderen Fläche (38) aufweist, auf der die ECU (20, 20') befestigt werden kann, wobei das Gehäuse mit einer in der Mitte liegenden Tasche (36) zur Aufnahme irgendwelcher Bauteile (28) ausgebildet ist, die von der hinteren Fläche (26) der ECU aus vorspringen; wobei die Kühlplatte (30) weiterhin einen Kanal (40) innerhalb des Gehäuses umfasst, durch den die Kühlflüssigkeit strömen kann, und wobei die ECU (20) eine hintere Auflageplatte, die eine im Wesentlichen am Umfang vorgesehene Oberfläche (26) umfasst, die mit der ebenen vorderen Fläche (38) der Kühlplatte zusammenpasst und die gekühlt werden muss, sowie einen Kasten (28) umfasst, der von dieser Oberfläche (26) aus vorspringt; wobei der Kanal Strömungsmittelleitungen (40) umfasst, durch die Treibstoff im Wesentlichen lediglich um zumindest einen Teil des Umfanges der in der Mitte angeordneten Tasche (36) herumströmt, um Wärme auf den Treibstoff von den Bereichen der Vorderfläche (38) zu übertragen, die die Tasche (36) umgeben.

2. Elektronische Steuereinheit (ECU) mit einer Kühlplatte nach Anspruch 1, **dadurch gekennzeichnet, dass** das Gehäuse (32, 34) der Kühlplatte mit Befestigungsvorsprüngen (52) zur Aufnahme von Stöße und Schwingungen absorbierenden Gummihülsen (54) versehen ist, um eine direkte Befestigung der Kühlplatte (30) an einem Motor zu ermöglichen.

3. Elektronische Steuereinheit mit einer Kühlplatte nach Anspruch 1 oder 2, **dadurch gekennzeichnet, dass** das Gehäuse (32, 34) der Kühlplatte aus einem Metallgussteil, das einen offenen Kanal (40) umgrenzt, der drei Seiten der in der Mitte liegenden Tasche (36) umgibt, und aus einer Deckplatte (34) zum Verschließen des offenen Kanals (40) zur Bildung der Treibstoff-Strömungsleitungen gebildet ist.

4. Elektronische Steuereinheit mit einer Kühlplatte nach Anspruch 3, **dadurch gekennzeichnet, dass** die Deckplatte (34) mit dem Metallgussteil verschweisst ist.

5. Elektronische Steuereinheit mit einer Kühlplatte nach Anspruch 3 oder 4, **dadurch gekennzeichnet, dass** der offene Kanal (40) ein oder mehrere Unterteilungen (42, 44) aufweist, derart, dass der Treibstoff in den Strömungsleitungen gezwungen ist, einem verschlungenen Pfad zu folgen.

6. Elektronische Steuereinheit (ECU) (20') für einen Motor, die eine hintere Fläche (26') und einen in der Mitte liegenden Kasten (28') aufweist, der die elektronischen Bauteile aufnimmt und von der hinteren Fläche (26') der ECU (20') vorspringt, wobei eine Platte (30'), die einen erhöhten Außenwandabschnitt, der sich um den Umfang der Platte (30') herum erstreckt, auf der ECU (20') in Abdichteingriff mit dem Rand der hinteren Fläche (26') befestigt ist, um in Kombination mit der hinteren Fläche (26') und dem Kasten (28') eine Kammer für die Zirkulation des Treibstoffes zum Kühlen der ECU (20') zu bilden, wobei die Kammer eine Strömungsmittelleitung umfasst, durch die der Treibstoff im Wesentlichen lediglich um zumindest einen Teil des Umfanges des Kastens (28') strömt, um Wärme auf den Treibstoff von Bereichen der hinteren Fläche (26') der ECU (20') abzuführen, die den Kasten (28') umgeben.

7. Elektronische Steuereinheit nach Anspruch 6, **dadurch gekennzeichnet, dass** die Platte (30') als Metallgussteil mit zumindest einer erhöhten Unterteilungswand (44') ausgebildet ist, die die den zentralen Kasten (28') umgebenden Bereiche der Kammer in eine gewundene Strömungsleitung unterteilt.

8. Elektronische Steuereinheit nach Anspruch 6 oder 7, **dadurch gekennzeichnet, dass** der untere Boden des in der Mitte angeordneten Kastens (28') sich eng benachbart zu der Platte (30') erstreckt, um den Treibstoff zu zwingen, auf einem Pfad um zumindest einen Teil des Umfanges des in der Mitte angeordneten Kastens (28') zu strömen.

9. Elektronische Steuereinheit nach den Ansprüchen 6-8, **dadurch gekennzeichnet, dass** ein durchgehendes Dichtungselement (62) sich um den Umfang des in der Mitte angeordneten Kastens (28') erstreckt, um den Treibstoff in der Kammer abzudichten.

10. Elektronische Steuereinheit nach einem der Ansprüche 6-9, **dadurch gekennzeichnet, dass** die ECU (20') lösbar an der Platte (30') mit Hilfe einer Vielzahl von Schrauben (60) befestigt ist.

## Revendications

1. Refroidisseur (30) pour le refroidissement de l'unité de commande électronique (UCE) d'un moteur, comprenant un carter (32, 34) possédant un devant plat (38) sur lequel l'UCE (20, 20') peut être montée, le carter étant constitué d'une poche centrale (36) pour accueillir les composants (28) qui dépassent de la face arrière (26) de l'UCE, le refroidisseur (30) comprenant en outre un passage (40) dans le carter à travers lequel le liquide de refroidissement peut s'écouler, et dans lequel
l'UCE (20) possède une plaque de renforcement arrière comprenant une surface (26) prévue de manière essentiellement circonférentielle, s'adaptant avec ledit devant plat (38) du refroidisseur et qui doit être refroidie, et un boîtier (28) qui dépasse de ladite surface (26) ; ledit passage (40) comprenant des conduits d'écoulement (40) à travers lesquels le carburant s'écoule uniquement pour l'essentiel autour d'au moins une partie de la périphérie de la poche centrale (36 de manière à transférer la chaleur du carburant depuis les régions du devant (38) entourant la poche (36).

2. Unité de commande électronique (UCE) avec un refroidisseur selon la revendication 1, **caractérisée en ce que** le carter du refroidisseur (32, 34) est formé avec des pastilles de montage (52) pour recevoir des douilles en caoutchouc absorbant les chocs et les vibrations (54), de manière à permettre le montage direct du refroidisseur (30) sur un moteur.

3. Unité de commande électronique (UCE) avec un refroidisseur selon la revendication 1 ou 2, **caractérisée en ce que** le carter du refroidisseur (32, 34) est formé d'une pièce moulée en métal définissant un profilé ouvert (40) entourant trois côtés de la poche centrale (36) et d'un couvercle (34) pour refermer le profilé ouvert (40) de manière à constituer les conduits d'écoulement du carburant.

4. Unité de commande électronique (UCE) avec un refroidisseur selon la revendication 3, **caractérisée en ce que** le couvercle (34) est soudé à la pièce moulée en métal.

5. Unité de commande électronique (UCE) avec un refroidisseur selon la revendication 3 ou 4, **caractérisée en ce que** le profilé ouvert (40) comprend une ou plusieurs séparations (42, 44) de manière telle que le carburant présent dans les conduits d'écoulement soit contraint de suivre un trajet contourné.

6. Unité de commande électronique (UCE) (20') pour un moteur possédant une face arrière (26') et un boîtier central (28') qui accueille les composants dépassant de la surface arrière (26') de l'UCE (20'), dans laquelle
une plaque (30') comprenant une partie de paroi extérieure relevée s'étendant sur la périphérie de la plaque (30') est montée sur l'UCE (20') en engagement de fermeture avec le bord de la face arrière (26') de manière à définir, en combinaison avec la face arrière (26') et le boîtier (28'), une chambre pour la circulation du carburant en vue du refroidissement de l'UCE (20'), ladite chambre comprenant un conduit d'écoulement à travers lequel du carburant s'écoule essentiellement autour d'une partie au moins seulement de la périphérie de la boîte (28') de manière à transférer la chaleur du carburant depuis les zones de la face arrière (26') de l'UCE (20') entourant le boîtier (28').

7. Unité de commande électronique selon la revendication 6, **caractérisée en ce que** la tôle (30') a la forme d'une pièce moulée en métal avec au moins un cloison de séparation relevée (44') qui divise les régions de la chambre entourant le boîtier central (28') dans un conduit d'écoulement contoumé.

8. Unité de commande électronique selon la revendication 6 ou 7, **caractérisée en ce qu'**un fond du boîtier central (28') s'étend de manière étroitement adjacente à la tôle (30') pour obliger le carburant à s'écouler selon un trajet autour d'au moins une partie de la périphérie dudit boîtier central (28').

9. Unité de commande électronique selon les revendication 6 à 8, **caractérisée en ce qu'**un élément de fermeture continu (62) s'étend autour de la périphérie du boîtier central (28') pour enfermer le carburant dans ladite chambre.

10. Unité de commande électronique selon l'une quelconque des revendication 6 à 9, **caractérisée en ce que** l'UCE (20') est fixée de manière amovible à la tôle (30') au moyen d'une pluralité de vis (60).
